(19) Europäisches Patentamt
European Patent Office
Office européen des brevets

(11) **EP 4 765 632 A1**

(12) **EUROPEAN PATENT APPLICATION**
published in accordance with Art. 153(4) EPC

(43) Date of publication:
**24.06.2026 Bulletin 2026/26**

(51) International Patent Classification (IPC):
**H03F 1/32** *(2006.01)*

(21) Application number: 24853656.7

(22) Date of filing: **08.08.2024**

(86) International application number:
**PCT/CN2024/110717**

(87) International publication number:
**WO 2025/036246 (20.02.2025 Gazette 2025/08)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **15.08.2023 CN 202311026828**

(71) Applicant: **Vanchip (Tianjin) Technology Co. Ltd
Tianjin 300457 (CN)**

(72) Inventors:
• **CHEN, Gang**
  **Tianjin 300457 (CN)**
• **BAI, Yunfang**
  **Tianjin 300457 (CN)**

(74) Representative: **Wang, Bo
Panovision IP
Ebersberger Straße 3
85570 Markt Schwaben (DE)**

(54) **LOAD MODULATION POWER AMPLIFIER AND CORRESPONDING ELECTRONIC DEVICE**

(57)    Disclosed in the present invention are a load modulation power amplifier and a corresponding electronic device. The load modulation power amplifier includes a driving-stage power amplifier and a bias circuit thereof, an input power divider, a harmonic impedance controller, a main-circuit power amplifier and a bias circuit thereof, an auxiliary-circuit power amplifier and a bias circuit thereof, and a load modulation power combiner, where the driving-stage power amplifier is provided with a transconductance-enhanced bias circuit, the main-circuit power amplifier is provided with a phase-adjustable bias circuit, and the auxiliary-circuit power amplifier is provided with a bias circuit with a controllable enabling power point. In cooperation with a harmonic impedance matching circuit and the load modulation power combiner that has less insertion loss, units collaboratively operate to realize linearization and high efficiency of the load modulation power amplifier, which can well meet requirements of actual applications.

FIG. 2

**Description**

**BACKGROUND**

**Technical Field**

The present invention relates to a load modulation power amplifier, and also relates to an electronic device including the load modulation power amplifier, and belongs to the field of radio frequency integrated circuit technologies.

**Related Art**

In some particular radio frequency power amplifier applications, such as satellite communication and a walkie-talkie, output power and efficiency of a power amplifier in a mobile device need to be improved. Because a modulation signal needs to be transmitted, the power amplifier needs to ensure linearity of an output signal within a rated power range. In addition, it is hoped to improve reliability and the service life of the mobile device, reduce power consumption, and reduce the device temperature as much as possible.

In the existing technology, each radio frequency power amplifier is designed based on a class A power amplifier or a class AB power amplifier, and good linearity is obtained through power back-off. However, efficiency of the class A power amplifier or the class AB power amplifier at back-off power is low, resulting in high power consumption of the power amplifier and high device temperature. A main advantage of a load modulation power amplifier is improving an efficiency value at back-off power, but linearity of the load modulation power amplifier is limited by change of a load line of a main-circuit power amplifier and switching of an operating state of an auxiliary-circuit power amplifier. Consequently, linearity of the load modulation power amplifier at output power back-off is poor, and good linearity needs to be obtained in cooperation with a digital pre-distortion algorithm of a transceiver. However, limited by techniques and power consumption, the transceiver on the mobile device generally provides no digital pre-distortion algorithm, or provides a digital pre-distortion algorithm with a limited capability. As a result, application of the load modulation power amplifier is limited by linearity.

Therefore, how to overcome the foregoing existing problem and provide a load modulation power amplifier having high operating efficiency and good linearity is still one of very important research topics in the field.

**SUMMARY**

A first technical problem to be resolved by the present invention is to provide a load modulation power amplifier.

Another technical problem to be resolved by the present invention is to provide an electronic device including the load modulation power amplifier.

To achieve the foregoing objectives, the present invention uses the following technical solutions:

According to a first aspect of embodiments of the present invention, provided is a load modulation power amplifier, including a driving-stage power amplifier and a bias circuit thereof, an input power divider, a harmonic impedance controller, a main-circuit power amplifier and a bias circuit thereof, an auxiliary-circuit power amplifier and a bias circuit thereof, and a load modulation power combiner, where

an input end of the driving-stage power amplifier and the bias circuit thereof is connected to a radio frequency signal input end, and is configured to drive and amplify an inputted radio frequency signal, and the amplified radio frequency signal is outputted to the input power divider;

the input power divider is configured to divide one inputted radio frequency signal into two radio frequency signals with a phase difference of 90 degrees, where a radio frequency signal whose phase is +45 degrees passes through the harmonic impedance controller and then enters the main-circuit power amplifier; and a radio frequency signal whose phase is -45 degrees passes through the harmonic impedance controller and then enters the auxiliary-circuit power amplifier;

the main-circuit power amplifier and the bias circuit thereof and the auxiliary-circuit power amplifier and the bias circuit thereof are both configured to amplify the inputted radio frequency signals, and the amplified radio frequency signals are separately outputted to the load modulation power combiner; and

the load modulation power combiner is configured to perform power combination on the two inputted radio frequency signals to obtain one radio frequency signal, and has an output end connected to a radio frequency signal output end, where

the driving-stage power amplifier is provided with a transconductance-enhanced bias circuit, the main-circuit power amplifier is provided with a phase-adjustable bias circuit, and the auxiliary-circuit power amplifier is provided with a bias circuit with a controllable enabling power point and the harmonic impedance controller.

Preferably, an output end of the driving-stage power amplifier is connected to an input end of the input power divider, a first output end of the input power divider is connected to a first input end of the harmonic impedance controller, and a second output end of the input power divider is connected to a second input end of the harmonic impedance controller; a first output end of the harmonic impedance controller is connected to an input end of the main-circuit power amplifier and the bias circuit thereof, and a second output end of the harmonic impedance controller is connected to an input end of the auxiliary-circuit power amplifier and the bias circuit thereof; and an output end of the main-circuit power amplifier and the bias circuit thereof is connected to a first input end of the load modulation power combiner, and an output end of the auxiliary-circuit power amplifier and the bias circuit thereof is connected to a second input end of the load modulation power combiner.

Preferably, the driving-stage power amplifier and the bias circuit thereof include a driving and amplifying power tube, a first bias tube, a second bias tube, a first voltage stabilizing diode, a second voltage stabilizing diode, a third voltage stabilizing diode, a first filter capacitor, a second filter capacitor, a first feedback capacitor, a first bias resistor, a second bias resistor, and a first voltage stabilizing resistor, where

the driving and amplifying power tube has a base connected to the radio frequency signal input end, an emitter connected to a ground end, and a collector connected to an input end of the input power divider;
the first bias resistor, the first voltage stabilizing diode, the second voltage stabilizing diode, the first filter capacitor, and the first bias tube make up a main bias circuit, configured to provide a first bias current; and
the second bias resistor, the first voltage stabilizing resistor, the third voltage stabilizing diode, the second filter capacitor, the first feedback capacitor, and the second bias tube make up a transconductance-enhanced bias circuit, configured to provide a second bias current.

Preferably, in the main bias circuit, an emitter of the first bias tube is connected to the base of the driving and amplifying power tube, and a collector of the first bias tube and the first bias resistor are both connected to a first bias voltage terminal; and another end of the first bias resistor is connected to a base of the first bias tube, the first filter capacitor, and an anode of the first voltage stabilizing diode, a cathode of the first voltage stabilizing diode is connected to an anode of the second voltage stabilizing diode, and a cathode of the second voltage stabilizing diode and another end of the first filter capacitor are both connected to the ground end.

Preferably, in the transconductance-enhanced bias circuit, an emitter of the second bias tube is connected to the base of the driving and amplifying power tube and the first feedback capacitor, and another end of the first feedback capacitor is connected to the collector of the driving and amplifying power tube; a collector of the second bias tube and the second bias resistor are both connected to a first bias voltage terminal; and another end of the second bias resistor is connected to a base of the second bias tube, the first voltage stabilizing resistor, and the second filter capacitor, another end of the first voltage stabilizing resistor is connected to an anode of the third voltage stabilizing diode, and a cathode of the third voltage stabilizing diode and another end of the second filter capacitor are both connected to the ground end.

Preferably, when the driving-stage power amplifier outputs small power, the transconductance-enhanced bias circuit is in a disabled state, and does not provide the second bias current; and when output power of the driving-stage power amplifier is increased and exceeds a set threshold, the transconductance-enhanced bias circuit is enabled, and provide the second bias current, to increase transconductance of the driving and amplifying power tube.

Preferably, the input power divider includes a first inductor, a second inductor, a first capacitor, and a second capacitor, where an end of the first inductor, an end of the second inductor, an end of the first capacitor, and an end of the second capacitor are mutually connected and then connected, as an input end, to an output end of the driving-stage power amplifier and the bias circuit thereof;

the first inductor connected in parallel and the first capacitor connected in series make up a high-pass network, to cause a radio frequency signal phase of the channel to lead by 45 degrees, and another end of the first capacitor is connected, as a first output end, to a first input end of the harmonic impedance controller; and
the second inductor connected in series and the second capacitor connected in parallel make up a low-pass network, to cause a radio frequency signal phase of the channel to lag by 45 degrees, and another end of the second inductor is used as a second output end and is connected to a second input end of the harmonic impedance controller.

Preferably, the harmonic impedance controller includes a third inductor, a fourth inductor, a fifth inductor, a sixth inductor, a third capacitor, a fourth capacitor, a fifth capacitor, and a sixth capacitor, where the third inductor, the fifth inductor, the third capacitor, and the fifth capacitor make up a harmonic impedance matching circuit of the main-circuit power amplifier; the fourth inductor, the sixth inductor, the fourth capacitor, and the sixth capacitor make up a harmonic impedance matching circuit of the auxiliary-circuit power amplifier; and
Preferably, in the harmonic impedance matching circuit of the main-circuit power amplifier, an end of the third inductor and an end of the third capacitor are mutually connected and then connected, as a first input end of the harmonic impedance controller, to a first output end of the input power divider; another end of the third inductor and another end of the third capacitor are mutually connected, and then are connected to the fifth capacitor in an aspect and connected, as a first output end of the harmonic impedance controller, to an input end of the main-circuit power amplifier and the bias circuit thereof in another aspect; and another end of the fifth capacitor is connected to the fifth inductor, and another end of the fifth inductor is connected to a ground end.

Preferably, the main-circuit power amplifier and the bias circuit thereof include a main-circuit amplifying power tube, a third bias tube, a first transistor, a second transistor, a fourth voltage stabilizing diode, a fifth voltage stabilizing diode, a third filter capacitor, a first coupling capacitor, a third bias resistor, and a fourth bias resistor, where all elements except the main-circuit amplifying power tube make up a bias circuit;

in the bias circuit, the third bias tube is an emitter follower, configured to provide a bias current for the main-circuit amplifying power tube, and the fourth bias resistor is configured to control magnitude of the bias current; and the third bias resistor, the first coupling capacitor, the first transistor, and the second transistor make up a phase adjustment circuit, configured to improve phase characteristics.

Preferably, in the main-circuit power amplifier and the bias circuit thereof, a base of the main-circuit amplifying power tube is connected to an emitter of the third bias tube and then is connected to a first output end of the harmonic impedance controller; an emitter of the main-circuit amplifying power tube is connected to a ground end, and a collector of the main-circuit amplifying power tube is connected, as an output end, to a first input end of the load modulation power combiner; a collector of the third bias tube, the third bias resistor, and the fourth bias resistor are connected and then jointly connected to a second bias voltage end; another end of the third bias resistor is connected to a collector of the first transistor and a collector of the second transistor; a base of the first transistor is connected to the emitter of the third bias tube by using the third filter capacitor; a base and an emitter of the second transistor are connected in parallel and then connected to the ground end, and an emitter of the first transistor is connected to the ground end; a base of the third bias tube is connected to the third filter capacitor, an anode of the fourth voltage stabilizing diode, and another end of the fourth bias resistor; and another end of the third filter capacitor is connected to the ground end, a cathode of the fourth voltage stabilizing diode is connected to an anode of the fifth voltage stabilizing diode, and a cathode of the fifth voltage stabilizing diode is connected to the ground end.

Preferably, the auxiliary-circuit power amplifier and the bias circuit thereof include an auxiliary-circuit amplifying power tube, a fourth bias tube, a sixth voltage stabilizing diode, a fourth filter capacitor, a fifth bias resistor, and a second voltage stabilizing resistor, where all elements except the auxiliary-circuit amplifying power tube make up a bias circuit;

in the bias circuit, the fifth bias resistor is configured to control the enabling power point of the auxiliary-circuit power amplifier; and the fourth bias tube is an emitter follower, configured to provide a bias current for the auxiliary-circuit amplifying power tube; and when the inputted radio frequency signal in a small signal state, the fourth bias tube is in a half cut-off state and provides no bias current; and when the inputted radio frequency signal is in a large signal state, the fourth bias tube begins to provide a bias current, to enable the auxiliary-circuit amplifying power tube, rapidly increase output power, and realize a load modulation effect.

Preferably, in the auxiliary-circuit power amplifier and the bias circuit thereof, a base of the auxiliary-circuit amplifying power tube is connected to an emitter of the fourth bias tube and then is connected to a second output end of the harmonic impedance controller; an emitter of the auxiliary-circuit amplifying power tube is connected to a ground end, and a collector of the auxiliary-circuit amplifying power tube is connected, as an output end, to a second input end of the load modulation power combiner; a collector of the fourth bias tube and the fifth bias resistor are connected and then jointly connected to a third bias voltage end; and another end of the fifth bias resistor is connected to a base of the fourth bias tube, the second voltage stabilizing resistor, and the fourth filter capacitor, another end of the second voltage stabilizing resistor is connected to an anode of the sixth voltage stabilizing diode, and a cathode of the sixth voltage stabilizing diode and another end of the fourth filter capacitor are both connected to the ground end.

Preferably, the load modulation power combiner includes a seventh inductor, an eighth inductor, a ninth inductor, a tenth inductor, an eleventh inductor, a seventh capacitor, an eighth capacitor, a ninth capacitor, a tenth capacitor, and an eleventh capacitor, where

the seventh inductor, the seventh capacitor, and the eighth capacitor make up a CLC-type main-circuit matching network; the eighth inductor, the ninth inductor, the tenth inductor, the ninth capacitor, and the tenth capacitor make up a CL+CLL-type auxiliary-circuit matching network; and the eleventh inductor and the eleventh capacitor make up an LC-type combinatorial matching network.

Preferably, in the load modulation power combiner, an end of the seventh capacitor is connected, as a first input end, to an output end of the main-circuit power amplifier and the bias circuit thereof, another end of the seventh capacitor is connected to the seventh inductor, another end of the seventh inductor is connected to the eighth capacitor and the eleventh inductor, and another end of the eighth capacitor is connected to a ground end; an end of the ninth capacitor and an end of the tenth capacitor are connected and then connected, as a second input end, to an output end of the auxiliary-circuit power amplifier and the bias circuit thereof, another end of the tenth capacitor is connected to the tenth inductor, and another end of the tenth inductor is connected to the ground end; another end of the ninth capacitor is connected to the eighth inductor and the ninth inductor, another end of the eighth inductor is connected to the ground end, and another end of the ninth inductor is connected to the eighth capacitor and the eleventh inductor; and another end of the eleventh inductor is connected to the eleventh capacitor and the radio frequency signal output end of the load modulation power amplifier, and another end of the eleventh capacitor is connected to the ground end.

According to a second aspect of the embodiments of the present invention, provided is an electronic device, including the foregoing load modulation power amplifier.

Compared with the existing technology, according to the load modulation power amplifier provided in the present invention, by using the technical solution in which the driving-stage power amplifier is provided with the transconductance booster bias circuit, and the main circuit and the auxiliary circuit are provided with the harmonic impedance matching circuit, and the technical solution in which the main-circuit power amplifier is provided with the bias circuit with a phase adjustment circuit and the auxiliary-circuit power amplifier is provided with the bias circuit with a controllable enabling power point, and with reference to the output end provided with the load modulation power combiner that has less insertion loss, units collaboratively operate to realize linearization and high efficiency of the load modulation power amplifier, which can well meet the requirements of actual applications. Therefore, the load modulation power amplifier provided by the present invention has beneficial effects such as skillful and proper structural design, low design costs, high operating efficiency, and excellent circuit performance.

## BRIEF DESCRIPTION OF THE DRAWINGS

FIG. 1 is a schematic structural diagram of a typical load modulation power amplifier in the existing technology;

FIG. 2 is a schematic structural diagram of a load modulation power amplifier according to an embodiment of the present invention;

FIG. 3 is a general circuit principle diagram of a load modulation power amplifier according to an embodiment of the present invention;

FIG. 4 is a circuit principle diagram of a driving-stage power amplifier and a bias circuit thereof according to an embodiment of the present invention;

FIG. 5 is a simulation test chart of a change of a second bias current provided by a transconductance booster bias circuit with output power according to an embodiment of the present invention;

FIG. 6 is a simulation test chart of comparison between gain changes with output power in cases in which a transconductance booster bias circuit operates and the transconductance booster bias circuit does not operate according to an embodiment of the present invention;

FIG. 7 is a circuit principle diagram of a main-circuit power amplifier and a bias circuit thereof according to an embodiment of the present invention;

FIG. 8 is a simulation test chart of comparison between phase changes with output power in cases in which a phase adjustment circuit is disposed and no phase adjustment circuit is disposed according to an embodiment of the present invention;

FIG. 9 is a circuit principle diagram of an auxiliary-circuit power amplifier and a bias circuit thereof according to an embodiment of the present invention;

FIG. 10 is a simulation test chart of gain changes of a load modulation power amplifier with output power when an auxiliary-circuit amplifying power tube (class C) is at different enabling power points according to an embodiment of the present invention;

FIG. 11 is a principle diagram of load line conversion of a load modulation power amplifier according to an embodiment of the present invention;

FIG. 12 is a circuit principle diagram of a load modulation power combiner according to an embodiment of the present invention;

FIG. 13 is an equivalent circuit principle diagram of a load modulation power combiner during input of a small signal according to an embodiment of the present invention;

FIG. 14 is a simulation test chart of linearity of a load modulation power amplifier according to an embodiment of the present invention;

FIG. 15 is a simulation test chart of efficiency of a load modulation power amplifier according to an embodiment of the present invention; and

FIG. 16 is a schematic diagram of an electronic device using a load modulation power amplifier according to an embodiment of the present invention.

**DETAILED DESCRIPTION**

The following describes the technical content of the present invention in detail and with reference to the accompanying drawings and specific embodiments.

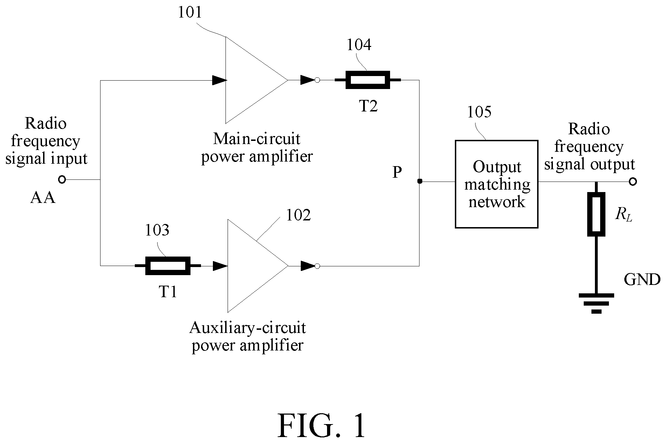

As shown in FIG. 1, a typical load modulation power amplifier in the existing technology includes a main-circuit power amplifier 101, an auxiliary-circuit power amplifier 102, a quarter-wave input transmission line 103, a quarter-wave output transmission line 104, and an output matching network 105.

Ideally, when a radio frequency signal is inputted to a radio frequency signal input end, a part of the radio frequency signal is inputted to a main-circuit power amplifier branch, amplified through the main-circuit power amplifier 101, and transmit to the output matching network 105 through the quarter-wave output transmission line 104; and another part of the radio frequency signal is inputted to an auxiliary-circuit power amplifier branch, passes through the quarter-wave input transmission line 103, and then is amplified through the auxiliary-circuit power amplifier 102, and outputted to the output matching network 105. The output matching network 105 combines the two signals and then outputs a radio frequency signal. The main-circuit power amplifier 101 is in a class AB bias state, and is in an enabled state in a case of a small signal; the auxiliary-circuit power amplifier 102 is in a class C bias state, and is in a disabled state in a case of a small signal; and when an input signal is sufficiently large, the auxiliary-circuit power amplifier 102 is enabled, to enter a signal amplified state.

After the auxiliary-circuit power amplifier 102 is enabled, load impedance of the main-circuit power amplifier 101 is reduced, and output power of the auxiliary-circuit power amplifier 102 is nonlinearly increased. If a gain curve and a phase curve are not optimized, linearity of the load modulation power amplifier is poor.

In the existing technology, in the load modulation power amplifier, the quarter-wave output transmission line 104 and the output matching network 105 are circuit power loss points. Because the quarter-wave output transmission line 104 needs to present a high load line to the main-circuit power amplifier 101 at small power, and the quarter-wave output transmission line 104 needs to present a low load line to the main-circuit power amplifier 101 at large power, switching between impedance conversion ratios of the quarter-wave output transmission line 104 at different power causes a large circuit power consumption loss.

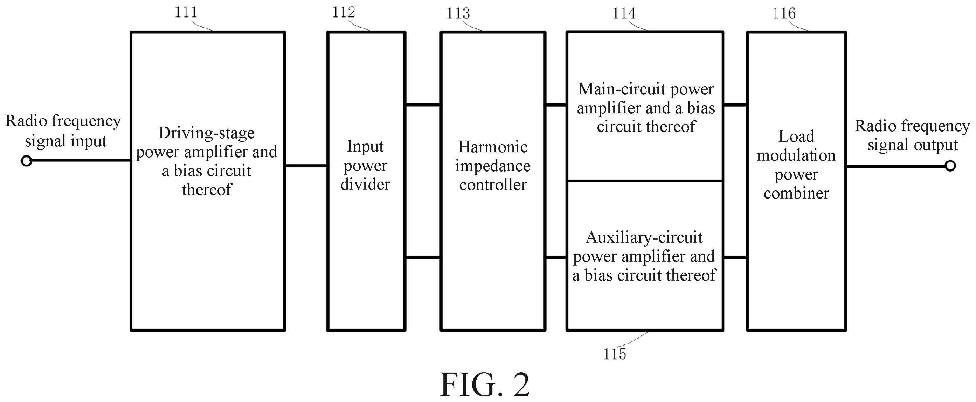

To resolve the foregoing problem existing in the existing technology, as shown in FIG. 2, an embodiment of the present invention provides a load modulation power amplifier with high operating efficiency and good linearity, including a driving-stage power amplifier and a bias circuit 111 thereof, an input power divider 112, a harmonic impedance controller 113, a main-circuit power amplifier and a bias circuit 114 thereof, an auxiliary-circuit power amplifier and a bias circuit 115 thereof, and a load modulation power combiner 116. A radio frequency signal input end of the load modulation power amplifier is connected to an input end of the driving-stage power amplifier and the bias circuit 111 thereof, an output end of the driving-stage power amplifier and the bias circuit 111 thereof is connected to an input end of the input power divider 112, a first output end of the input power divider 112 is connected to a first input end of the harmonic impedance controller 113, and a second output end of the input power divider 112 is connected to a second input end of the harmonic impedance controller 113; a first output end of the harmonic impedance controller 113 is connected to an input end of the main-circuit power amplifier and the bias circuit 114 thereof, and a second output end of the harmonic impedance controller 113 is connected to an input end of the auxiliary-circuit power amplifier and the bias circuit 115 thereof; an output end of the main-circuit power amplifier and the bias circuit 114 thereof is connected to a first input end of the load modulation power combiner 116, and an output end of the auxiliary-circuit power amplifier and the bias circuit 115 thereof is connected to a second input end of the load modulation power combiner 116; and an output end of the load modulation power combiner 116 is connected to a radio frequency signal output end of the load modulation power amplifier.

In the load modulation power amplifier, when the radio frequency signal input end thereof receives input of a radio frequency signal, the driving-stage power amplifier first drives and amplifies the radio frequency signal, and outputs the driven and amplified radio frequency signal to the input power divider. The input power divider divides one inputted radio frequency signal into two radio frequency signals with a phase difference of 90 degrees, where a radio frequency signal whose phase is +45 degrees passes through the harmonic impedance controller and then enters the main-circuit power amplifier; and a radio frequency signal whose phase is -45 degrees passes through the harmonic impedance controller and then enters the auxiliary-circuit power amplifier. The main-circuit power amplifier and the auxiliary-circuit power amplifier respectively amplify radio frequency signals with a phase difference of 90 degrees, and then respectively output the amplified radio frequency signals to the load modulation power combiner 116, and the load modulation power combiner 116 performs power combination on the two radio frequency signals and then outputs one radio frequency signal at the radio frequency signal output end.

When an inputted radio frequency signal is in a small signal state, the auxiliary-circuit power amplifier is not enabled, a main-circuit power amplifier branch presents high load line impedance; or when an inputted radio frequency signal is in a large signal state, the auxiliary-circuit power amplifier is enabled, both a main-circuit power amplifier branch and an auxiliary-circuit power amplifier branch present low load line impedance.

The bias circuit of the main-circuit power amplifier, the bias circuit of the auxiliary-circuit power amplifier, and a harmonic impedance matching circuit (that is, a harmonic impedance controller) are each configured to optimize a gain curve and a phase curve of a power amplifier; the bias circuit of the driving-stage power amplifier is configured to optimize P1dB (1-decibel compression output power) of a power amplifier; and the four circuits jointly and harmoniously operate to improve linearity of the load modulation power amplifier.

The load modulation power combiner 116 is made up of lumped elements, including a main-circuit matching network, an auxiliary-circuit matching network, and a combinatorial matching network. An insertion loss thereof is less than that of a load line structure of the load modulation power amplifier in the existing technology, which can significantly improve efficiency of the load modulation power amplifier at back-off power.

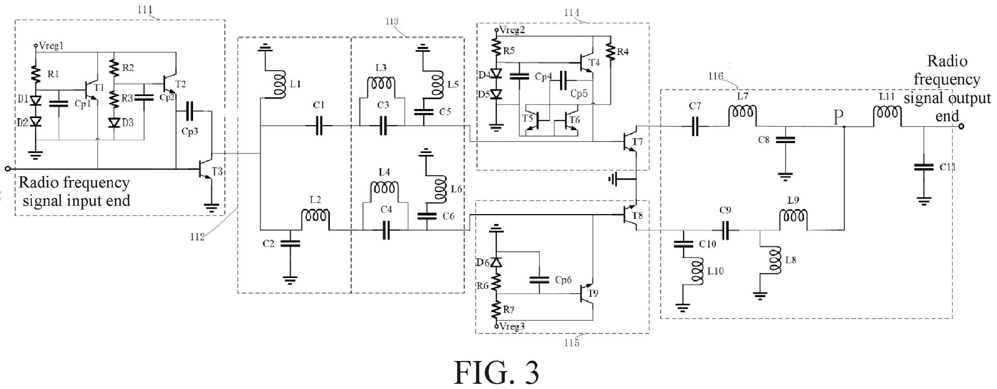

In an embodiment of the present invention, A general circuit principle diagram of a load modulation power amplifier is shown in FIG. 3. Compositions and structures of such units as a driving-stage power amplifier and a bias circuit 111 thereof, an input power divider 112, a harmonic impedance controller 113, a main-circuit power amplifier and a bias circuit 114 thereof, an auxiliary-circuit power amplifier and a bias circuit 115 thereof, and a load modulation power combiner 116 are separately described in detail as follows:

The driving-stage power amplifier and the bias circuit 111 thereof include a driving and amplifying power tube T3, a first bias tube T1, a second bias tube T2, a first voltage stabilizing diode D1, a second voltage stabilizing diode D2, a third voltage stabilizing diode D3, a first filter capacitor Cp1, a second filter capacitor Cp2, a first feedback capacitor Cp3, a first bias resistor R1, a second bias resistor R2, and a first voltage stabilizing resistor R3. The first bias resistor R1, the first voltage stabilizing diode D1, the second voltage stabilizing diode D2, the first filter capacitor Cp1 and the first bias tube T1 make up a main bias circuit; and the second bias resistor R2, the first voltage stabilizing resistor R3, the third voltage stabilizing diode D3, the second filter capacitor Cp2, the first feedback capacitor Cp3, and the second bias tube T2 make up a transconductance booster (Gm-booster) bias circuit.

In the driving-stage power amplifier and the bias circuit thereof, a radio frequency signal input end of the load modulation power amplifier is connected to a base of the driving and amplifying power tube T3, an emitter of the first bias tube T1, and an emitter of the second bias tube T2; an emitter of the driving and amplifying power tube T3 is connected to a ground end, and a collector of the driving and amplifying power tube T3 is connected, as an output end of the driving-stage power amplifier and the bias circuit thereof, to an input end of the input power divider, and is further connected to the first feedback capacitor Cp3; another end of the first feedback capacitor Cp3 is connected to the emitter of the second bias tube T2; a collector of the second bias tube T2, a collector of the first bias tube T1, the first bias resistor R1, and the second bias resistor R2 are each connected to a first bias voltage terminal Vreg1; another end of the second bias resistor R2 is connected to a base of the second bias tube T2, the first voltage stabilizing resistor R3, and the second filter capacitor Cp2, another end of the first voltage stabilizing resistor R3 is connected to an anode of the third voltage stabilizing diode D3, and a cathode of the third voltage stabilizing diode D3 and another end of the second filter capacitor Cp2 are both connected to the ground end; and another end of the first bias resistor R1 is connected to a base of the first bias tube T1, the first filter capacitor Cp1, and an anode of the first voltage stabilizing diode D1, a cathode of the first voltage stabilizing diode D1 is connected to an anode of the second voltage stabilizing diode D2, and a cathode of the second voltage stabilizing diode D2 and another end of the first filter capacitor Cp1 are both connected to the ground end.

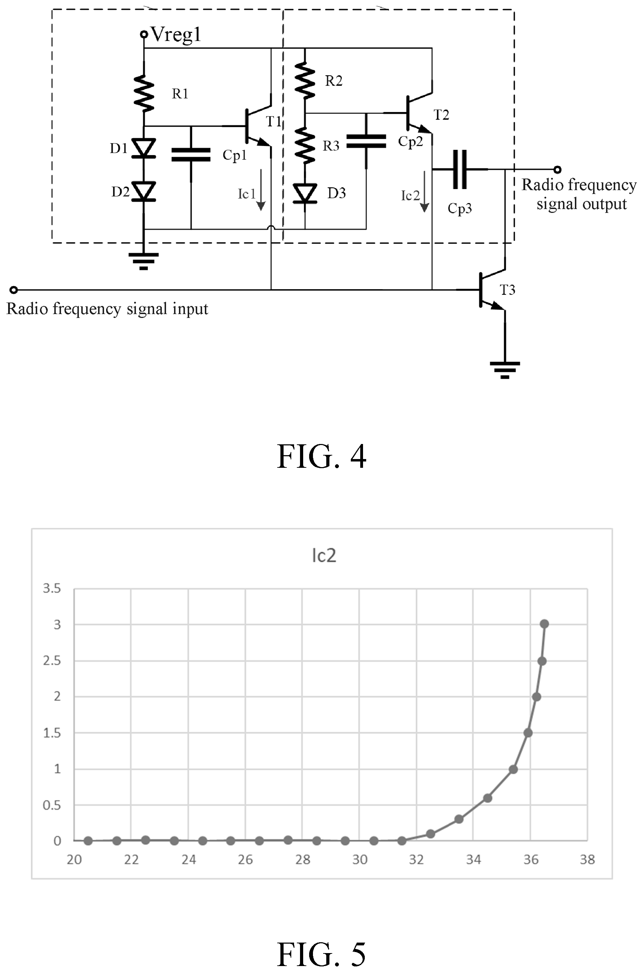

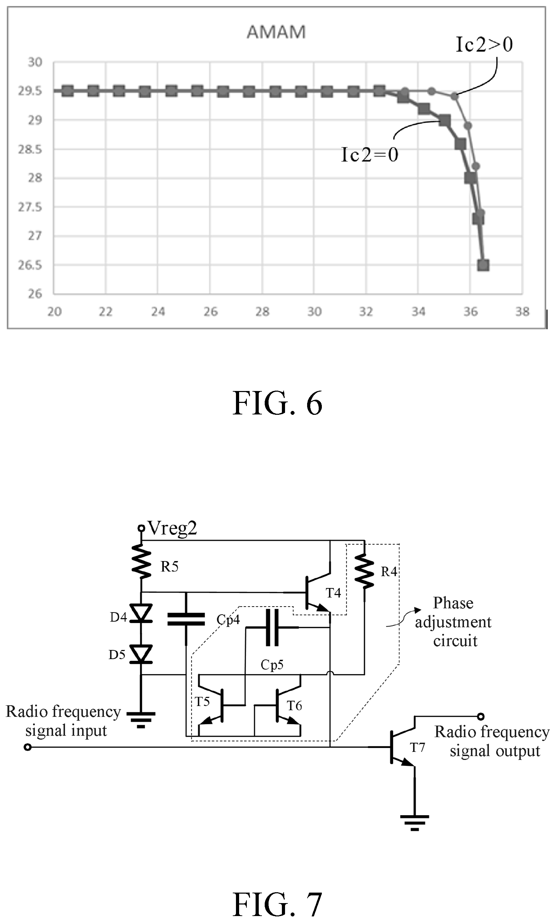

An operating principle of the driving-stage power amplifier and the bias circuit thereof is shown in FIG. 4. When the driving-stage power amplifier outputs small power, the main bias circuit provides a first bias current Ic1 to cause the driving and amplifying power tube T3 to be in an enabled state, and the transconductance booster bias circuit is not enabled and provides no bias current. When the driving-stage power amplifier outputs large power, the bias current Ic1 provided by the main bias circuit does not change. As the output power is gradually increased, the first feedback capacitor Cp3 feeds back driving-stage output power to the emitter of the second bias tube T2 of the transconductance booster bias circuit, so that the second bias tube T2 is enabled and provides a second bias current Ic2. In this case, the bias current of the driving and amplifying power tube T3 is increased, so that the transconductance (Gm) of the driving and amplifying power tube T3 is increased, to increase P1dB of the power amplifier. That is, only when the input power of the driving and amplifying power tube T3 exceeds a preset threshold, the transconductance booster bias circuit is enabled. For details of a specific operating process thereof, refer to FIG. 5 and FIG. 6.

FIG. 5 shows a situation of a change of the second bias current Ic2 provided by the transconductance booster bias circuit with an increase in output power. It can be seen from FIG. 5 that, when the output power is small power, the second bias current Ic2 is zero, that is, the transconductance booster bias circuit provides no bias current; and when the output power exceeds a specific value and continues to gradually increase, the second bias current Ic2 quickly increases accordingly.

FIG. 6 shows comparison between situations of gain changes with output power in cases in which the transconductance booster bias circuit operates (Ic2>0) and the transconductance booster bias circuit does not operate (Ic2=0). It can be seen from FIG. 6 that, the transconductance booster bias circuit can effectively increase P1dB of the power amplifier, thereby improving linearity.

The input power divider 112 includes a first inductor L1, a second inductor L2, a first capacitor C1, and a second capacitor C2. An end of the first inductor L1, an end of the second inductor L2, an end of the first capacitor C1, and an end of the second capacitor C2 are mutually connected and then connected, as an input end of the input power divider, to an output end of the driving-stage power amplifier and the bias circuit thereof; another end of the first inductor L1 and another end of the second capacitor C2 are separately connected to the ground end; another end of the first capacitor C1 is connected, as a first output end of the input power divider, to a first input end of the harmonic impedance controller; and another end of the second inductor L2 is connected, as a second output end of the input power divider, to a second input end of the harmonic impedance controller.

A radio frequency signal is amplified by the through driving-stage power amplifier and then outputted to the input power divider. The input power divider divides one inputted radio frequency signal into two radio frequency signals whose amplitudes are the same and whose phase difference is 90 degrees and then outputs the two radio frequency signals to the harmonic impedance controller. A radio frequency signal phase difference is generated by using a matching circuit structure. The first inductor L1 connected in parallel and the first capacitor C1 connected in series make up a high-pass network, to cause a radio frequency signal phase of the channel to lead, and the second inductor L2 connected in series and the second capacitor C2 connected in parallel make up a low-pass network, to cause a radio frequency signal phase of the channel to lag, thereby obtaining two radio frequency signals whose phase difference is 90 degrees.

The harmonic impedance controller 113 includes a third inductor L3, a fourth inductor L4, a fifth inductor L5, a sixth inductor L6, a third capacitor C3, a fourth capacitor C4, a fifth capacitor C5, and a sixth capacitor C6. The third inductor L3, the fifth inductor L5, the third capacitor C3 and the fifth capacitor C5 make up a harmonic impedance matching circuit of the main-circuit power amplifier; the fourth inductor L4, the sixth inductor L6, the fourth capacitor C4 and the sixth capacitor C6 make up a harmonic impedance matching circuit of the auxiliary-circuit power amplifier; and circuit structures of the two harmonic impedance matching circuits are completely the same.

In the harmonic impedance matching circuit of the main-circuit power amplifier, an end of the third inductor L3 and an end of the third capacitor C3 are mutually connected and then connected, as a first input end of the harmonic impedance controller, to a first output end of the input power divider; another end of the third inductor L3 and another end of the third capacitor C3 are mutually connected, and then are connected to the fifth capacitor C5 in an aspect and connected, as a first output end of the harmonic impedance controller, to an input end of the main-circuit power amplifier and the bias circuit thereof in another aspect; and another end of the fifth capacitor C5 is connected to the fifth inductor L5, and another end of the fifth inductor L5 is connected to the ground end.

In the harmonic impedance matching circuit of the auxiliary-circuit power amplifier, an end of the fourth inductor L4 and an end of the fourth capacitor C4 are mutually connected and then connected, as a second input end of the harmonic impedance controller, to a second output end of the input power divider; another end of the fourth inductor L4 and another end of the fourth capacitor C4 are mutually connected, and then are connected to the sixth capacitor C6 in an aspect and connected, as a second output end of the harmonic impedance controller, to an input end of the auxiliary-circuit power amplifier and the bias circuit thereof in another aspect; and another end of the sixth capacitor C6 is connected to the sixth inductor L6, and another end of the sixth inductor L6 is connected to the ground end.

The harmonic impedance controller includes the harmonic impedance matching circuit of the main-circuit power amplifier and the harmonic impedance matching circuit of the auxiliary-circuit power amplifier that are structurally the same, optimal efficiency impedance points of the main-circuit power amplifier and the auxiliary-circuit power amplifier can be determined by using source pull simulation design (source pull), and the main-circuit amplifying power tube and the auxiliary-circuit amplifying power tube are matched to the vicinity of an optimal fundamental impedance point and an optimal harmonic impedance point by using the harmonic impedance controller. Each matching circuit is made up of a parallel resonant circuit and a series resonant circuit. A resonant frequency of the parallel resonant circuit is at a third order, a resonant frequency of the series resonant circuit is at a second order, and source impedances of the main-circuit amplifying power tube and the auxiliary-circuit amplifying power tube have a second-order impedance that is a low impedance and a third-order impedance that is a high impedance, so that an input waveform is in a shape close to a square wave shape, to increase efficiency of the circuit.

The main-circuit power amplifier and the bias circuit 114 thereof include a main-circuit amplifying power tube T7, a third bias tube T4, a first transistor T5, a second transistor T6, a fourth voltage stabilizing diode D4, a fifth voltage stabilizing diode D5, a third filter capacitor Cp4, a first coupling capacitor Cp5, a third bias resistor R4, and a fourth bias resistor R5. All elements except the main-circuit amplifying power tube T7 make up a bias circuit thereof.

In the main-circuit power amplifier and the bias circuit thereof, a base of the main-circuit amplifying power tube T7 is connected to an emitter of the third bias tube T4 and then is connected to a first output end of the harmonic impedance controller; and an emitter of the main-circuit amplifying power tube T7 is connected to the ground end, and a collector of the main-circuit amplifying power tube T7 is connected, as an output end of the main-circuit power amplifier and the bias circuit thereof, to a first input end of the load modulation power combiner unit. A collector of the third bias tube T4, the third bias resistor R4, and the fourth bias resistor R5 are connected and then jointly connected to a second bias voltage end Vreg2; another end of the third bias resistor R4 is connected to a collector of the first transistor T5 and a collector of the second transistor T6; a base of the first transistor T5 is connected to the emitter of the third bias tube T4 by using the third filter capacitor Cp4; a base and an emitter of the second transistor T6 are connected in parallel and then connected to the ground end, and an emitter of the first transistor T5 is connected to the ground end; a base of the third bias tube T4 is connected to the third filter capacitor Cp4, an anode of the fourth voltage stabilizing diode D4, and another end of the fourth bias resistor R5; and another end of the third filter capacitor Cp4 is connected to the ground end, a cathode of the fourth voltage stabilizing diode D4 is connected to an anode of the fifth voltage stabilizing diode D5, and a cathode of the fifth voltage stabilizing diode D5 is connected to the ground end.

As shown in FIG. 7 (which is the same as the unit 114 in FIG. 2), in the bias circuit of the main-circuit amplifying power tube T7, the fourth bias resistor R5 is configured to control magnitude of the provided bias current, and the third bias tube T4 is an emitter follower, configured to provide a bias current for the main-circuit amplifying power tube T7. The third bias resistor R4, the first coupling capacitor Cp5, the first transistor T5, and the second transistor T6 make up a phase adjustment circuit. The third bias resistor R4 is configured to control bias points of the first transistor T5 and the second transistor T6, and the first coupling capacitor Cp5 is configured to control phase adjustment amplitude, and couple the power inputted to the main-circuit power amplifier to the first transistor T5 and the second transistor T6, to improve phase characteristics of the circuit by using a large signal to change junction capacitance of the first transistor T5 and the second transistor T6.

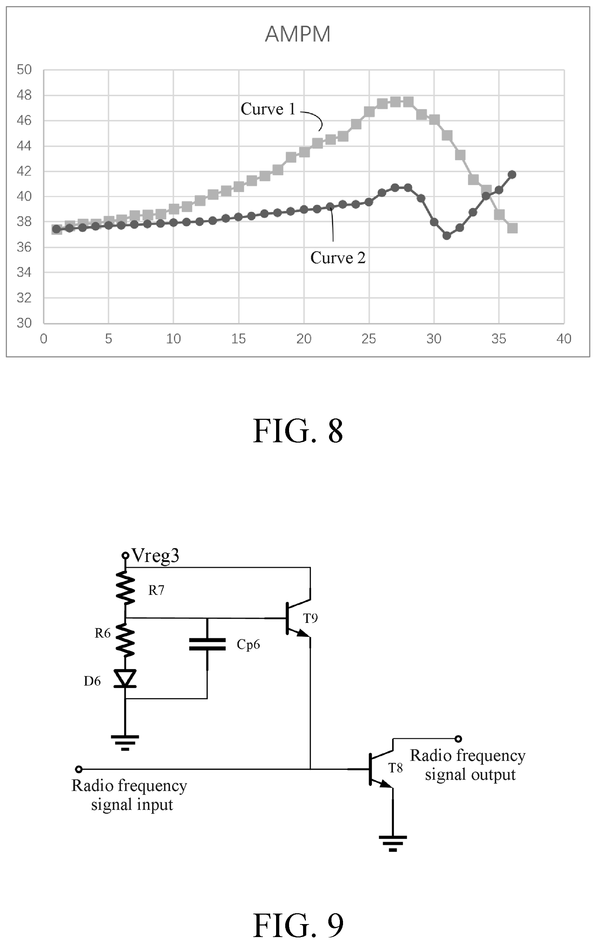

For details of a function of the phase adjustment circuit, refer to a situation in which a phase changes as output power increases shown in FIG. 8, where a curve 1 shows a phase change situation in which no phase adjustment circuit is disposed, and a curve 2 shows a phase change situation in which a phase adjustment circuit is disposed. It can be seen from FIG. 8 that, the phase adjustment circuit can well control a phase curve to approximately 2°, thereby improving linearity of the circuit.

The auxiliary-circuit power amplifier and the bias circuit 115 thereof includes an auxiliary-circuit amplifying power tube T8, a fourth bias tube T9, a sixth voltage stabilizing diode D6, a fourth filter capacitor Cp6, a fifth bias resistor R7, and a second voltage stabilizing resistor R6. All elements except the auxiliary-circuit amplifying power tube T8 make up a bias circuit thereof.

In the auxiliary-circuit power amplifier and the bias circuit thereof, a base of the auxiliary-circuit amplifying power tube T8 is connected to an emitter of the fourth bias tube T9 and then is connected to a second output end of the harmonic impedance controller; and an emitter of the auxiliary-circuit amplifying power tube T8 is connected to the ground end, and a collector of the auxiliary-circuit amplifying power tube T8 is connected, as an output end of the auxiliary-circuit power amplifier and the bias circuit thereof, to a second input end of the load modulation power combiner unit. A collector of the fourth bias tube T9 and the fifth bias resistor R7 are connected and then jointly connected to a third bias voltage end Vreg3; and another end of the fifth bias resistor R7 is connected to a base of the fourth bias tube T9, the second voltage stabilizing resistor R6, and the fourth filter capacitor Cp6, another end of the second voltage stabilizing resistor R6 is connected to an anode of the sixth voltage stabilizing diode D6, and a cathode of the sixth voltage stabilizing diode D6 and another end of the fourth filter capacitor Cp6 are both connected to the ground end.

The bias circuit of the auxiliary-circuit power amplifier is shown in FIG. 9 (which is the same as the unit 115 in FIG. 2). The fifth bias resistor R7 is configured to control an enabling power point of the auxiliary-circuit power amplifier, the second voltage stabilizing resistor R6 and the sixth voltage stabilizing diode D6 are voltage stabilizing circuits, and the fourth bias tube T9 is an emitter follower, configured to provide a bias current for the auxiliary-circuit amplifying power tube T8. In a small signal state, the fourth bias tube T9 is in a half cut-off state and provides no bias current, and the auxiliary-circuit amplifying power tube T8 is in a class C operating state; and as the input power is increased, the input amplitude of the auxiliary-circuit amplifying power tube T8 becomes larger, and the fourth bias tube T9 begins to provide a bias current, so that the auxiliary-circuit amplifying power tube T8 enters an amplifying mode, and the output power is quickly increased.

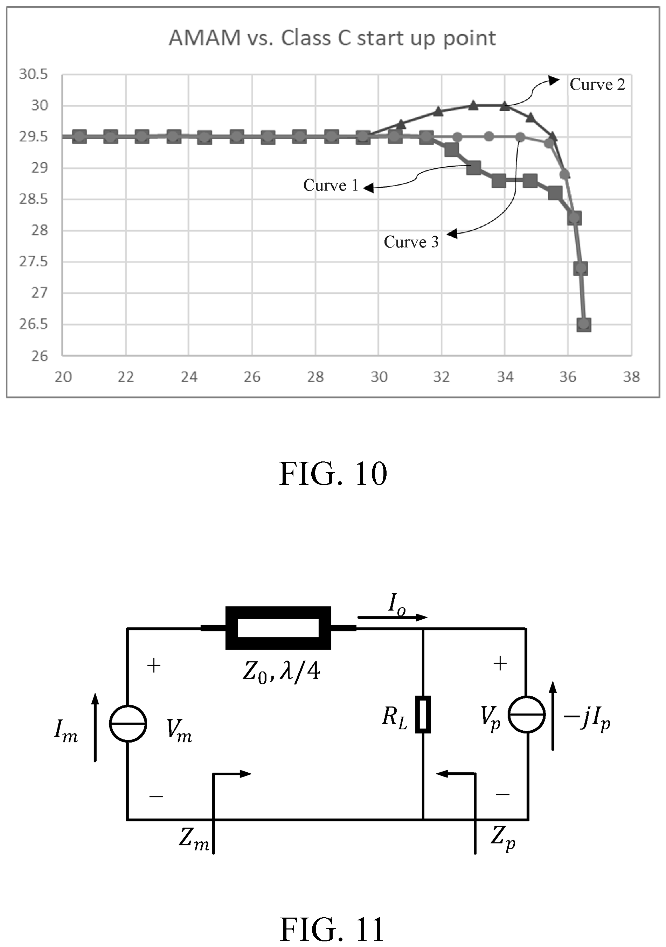

A gain curve of the load modulation power amplifier is directly correlated with the enabling power point of the auxiliary-circuit amplifying power tube T8 (that is, the class C power amplifier). FIG. 10 shows curves of gain changes of the load modulation power amplifier with an increase in output power when the class C power amplifier is at different enabling power points. As shown in a curve 1, the class C power amplifier is enabled at a large power point, and the enabling power point is close to saturation power. As a result, the gain curve declines excessively early, and P1dB is poor. As shown in a curve 2, the class C power amplifier is enabled at a small power point, and the enabling power point is close to small power. As a result, the gain curve warps up, and back-off linearity is poor. As shown in a curve 3, the class C power amplifier is enabled at a proper power point, so that P1dB of the load modulation power amplifier can be sufficiently high, thereby obtaining optimal linearity.

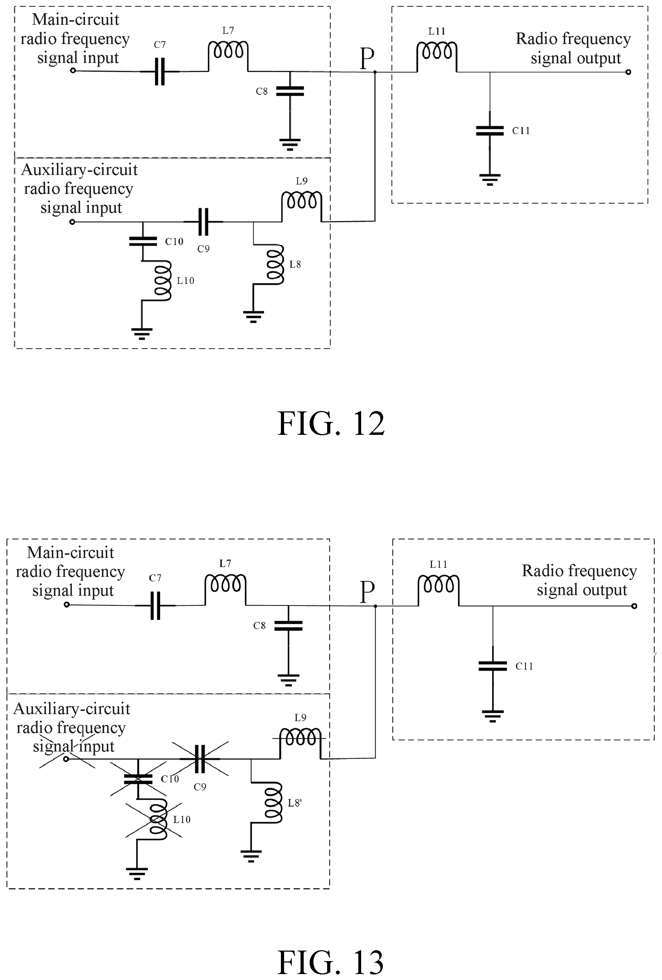

The load modulation power combiner 116 is made up of lumped elements, as shown in FIG. 12 (which is the same as the unit 116 in FIG. 2), including a seventh inductor L7, an eighth inductor L8, a ninth inductor L9, a tenth inductor L10, an eleventh inductor L11, a seventh capacitor C7, an eighth capacitor C8, a ninth capacitor C9, a tenth capacitor C10, and an eleventh capacitor C11. The seventh inductor L7, the seventh capacitor C7, and the eighth capacitor C8 make up a CLC-type main-circuit matching network; the eighth inductor L8, the ninth inductor L9, the tenth inductor L10, the ninth capacitor C9, and the tenth capacitor C10 make up a CL+CLL-type auxiliary-circuit matching network; and the eleventh inductor L11 and the eleventh capacitor C11 make up an LC-type combinatorial matching network.

In the load modulation power combiner, an end of the seventh capacitor C7 is connected, as a first input end of the load modulation power combiner, to an output end of the main-circuit power amplifier and the bias circuit thereof, another end of the seventh capacitor C7 is connected to the seventh inductor L7, another end of the seventh inductor L7 is connected to the eighth capacitor C8 and the eleventh inductor L11 (a node P), and another end of the eighth capacitor C8 is connected to a ground end; an end of the ninth capacitor C9 and an end of the tenth capacitor C10 are connected and then connected, as a second input end of the load modulation power combiner, to an output end of the auxiliary-circuit power amplifier and the bias circuit thereof, another end of the tenth capacitor C10 is connected to the tenth inductor L10, and another end of the tenth inductor L10 is connected to the ground end; another end of the ninth capacitor C9 is connected to the eighth inductor L8 and the ninth inductor L9, another end of the eighth inductor L8 is connected to the ground end, and another end of the ninth inductor L9 is connected to the eighth capacitor C8 and the eleventh inductor L11 (the node P); and another end of the eleventh inductor L11 is connected to the eleventh capacitor C11 and the radio frequency signal output end of the load modulation power amplifier, and another end of the eleventh capacitor C 11 is connected to the ground end.

Load line conversion of the load modulation power amplifier is shown in FIG. 11. Analyzing the load line conversion principle with the Kirchhoff theorem can deduce that a relationship between a main-circuit operating voltage and operating current and an auxiliary-circuit operating voltage and operating current is as follows:

$$\begin{bmatrix} V_m \\ I_m \end{bmatrix} = \begin{bmatrix} 0 & jZ_0 \\ j(1/Z_0) & 0 \end{bmatrix} \begin{bmatrix} V_p \\ I_o \end{bmatrix} \quad (1)$$

$$I_o = \frac{V_p}{R} + jI_p \quad (2)$$

$V_m$ is a main-circuit operating voltage, $I_m$ is a main-circuit operating current, $V_p$ is an auxiliary-circuit operating voltage, $I_p$ is an auxiliary-circuit operating current, $I_o$ is a current outputted after the main circuit passes through a transmission line, $Z_0$ is a characteristic impedance value of a main-circuit $\lambda/4$ transmission line ($\lambda$ is a transmission line wave length at an operating frequency), and R is an impedance of a power combining point (point P).

Through calculation, it can be learned that $Z_m$ of the main-circuit load line and $Z_p$ of the auxiliary-circuit load line are:

$$Z_m = \frac{Z_0^2}{R} - Z_0 \frac{I_p}{I_m} \quad (3)$$

$$Z_p = Z_0 \frac{I_m}{I_p} \quad (4)$$

It can be seen from the formula 3 and the formula 4 that, when the input radio frequency signal is a small signal, the auxiliary-circuit power amplifier is not enabled yet, that is, the auxiliary-circuit operating current $I_p$ is equal to 0. Assuming that R = (1/2)$Z_0$, the load line of the main-circuit power amplifier is $Z_m = Z_0^2/R = 2Z_0$ , and the load line of the auxiliary-circuit power amplifier is infinity. When the input radio frequency signal gradually becomes larger, to cause the main-circuit power amplifier to enter a saturation state, that is, the main-circuit operating current $I_m$ is unchanged, the auxiliary-circuit power amplifier is enabled. When the auxiliary-circuit operating current $I_p$ increases, the load line $Z_m$ of the main-circuit power amplifier gradually decreases, and the load line $Z_p$ of the auxiliary-circuit power amplifier also gradually decreases. Assuming that $I_p = I_m$ and R = (1/2)$Z_0$, the load line of the main-circuit power amplifier is

$$Z_m = Z_0^2/R - Z_0 = Z_0,$$

and the load line of the auxiliary-circuit power amplifier is $Z_p = Z_0$.

It can be known from the foregoing analysis that when the input signal becomes larger, the load line of the main-circuit power amplifier is reduced from $2Z_0$ to $Z_0$, to achieve an effect of load line modulation, and improve efficiency at back-off power; and the load line of the auxiliary-circuit power amplifier changes from infinity to $Z_0$, to improve output power of the load modulation power amplifier.

When the input radio frequency signal is a small signal, the load modulation power combiner shown in FIG. 12 may be equivalent to the equivalent circuit shown in FIG. 13. Because the auxiliary-circuit power amplifier has no output current, a device of the auxiliary-circuit matching network that participates in matching may be equivalently an inductor L8', which makes up a π-type network together with a combinatorial matching network, to convert the impedance at the point P into $4R_{opt}$. The function of the main-circuit matching network is to convert $Z_p$ into a lower impedance. If the impedance conversion ratio is 2, the load line of the main-circuit radio frequency power amplifier is $2R_{opt}$. $R_{opt}$ is a reference impedance designed for a matching network.

When the input radio frequency signal is a large signal, because the auxiliary-circuit power amplifier injects an operating current to the point P, the impedance at the point P is converted into $2R_{opt}$, so that the load line of the main-circuit power amplifier is reduced from $2R_{opt}$ to $R_{opt}$. In this case, the load line of the auxiliary-circuit power amplifier is $R_{opt}$.

A value of $Q_m$ of the main-circuit matching network is:

$$Q_m = \sqrt{\frac{2R_{opt}}{R_{opt}} - 1} = 1 \qquad (5)$$

A value of $Q_L$ of the combinatorial matching network is as follows: Assuming that $R_L$ is 50 Ohm and $R_{opt}$ is 6.25 Ohm, the following may be obtained through calculation:

$$Q_L = \sqrt{\frac{R_L}{4R_{opt}} - 1} = 1 \qquad (6)$$

Assuming that a value of $Q_u$ of a device in a matching network is 10, an insertion loss of the load modulation power amplifier may be obtained through calculation according to an insertion loss formula as follows:

$$\text{IL} = 10 \cdot log_{10}\left(\frac{1}{1+\frac{Q_m}{Q_u}} \cdot \frac{1}{1+\frac{Q_L}{Q_u}}\right) = -0.83 \, dBc \qquad (7)$$

The load modulation power combiner provided in this embodiment of the present invention may implement conversion from small power and large load to large power and small load, and keep a low insertion loss, facilitating improvement of operating efficiency.

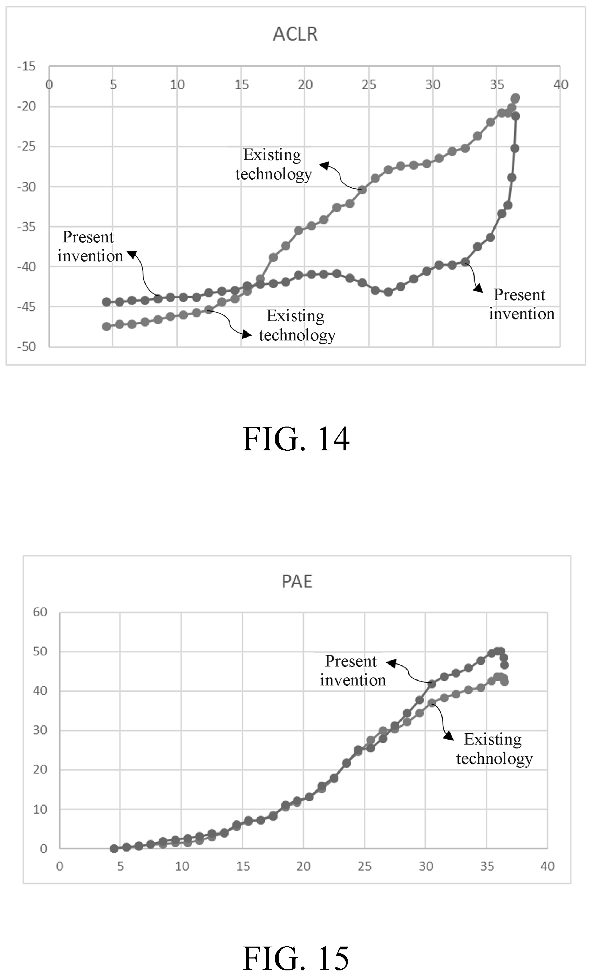

To verify the excellent performance of the load modulation power amplifier provided in this embodiment of the present invention, the inventor separately performs a simulation comparison test on the technical solution and the existing technical solution, and test results are shown in FIG. 14 and FIG. 15.

FIG. 14 is a simulation test result of linearity of the load modulation power amplifier. It may be learned from FIG. 14 that, as output power increases, an Adjacent Channel Leakage Ratio (ACLR) value of the load modulation power amplifier provided in the technical solution of this embodiment of the present invention is lower than an ACLR value of the existing technical solution. That is, linearity of the load modulation power amplifier provided in this embodiment of the present invention is significantly better than that of the existing technical solution.

FIG. 15 is a simulation test result of operating efficiency of the load modulation power amplifier. It may be learned from FIG. 15 that, as output power increases, the operating efficiency of the load modulation power amplifier provided in the technical solution of this embodiment of the present invention is significantly higher than the operating efficiency of the existing technical solution.

In addition, an embodiment of the present invention further provides an electronic device, including the foregoing load modulation power amplifier, which may be used as an important constituent part of a communication component. The electronic device described here refers to a computer device that can be used in mobile environments and support multiple communication standards such as GSM, EDGE, CDMA, TD_SCDMA, WCDMA, TDD_LTE, FDD_LTE, and NR, including a mobile phone, a laptop, a tablet, a vehicle-mounted computer, or the like. In addition, the technical solution provided in the present invention is also suitable for other occasions in which a radio frequency integrated circuit is applied, such as a communication base station and an intelligent connected vehicle.

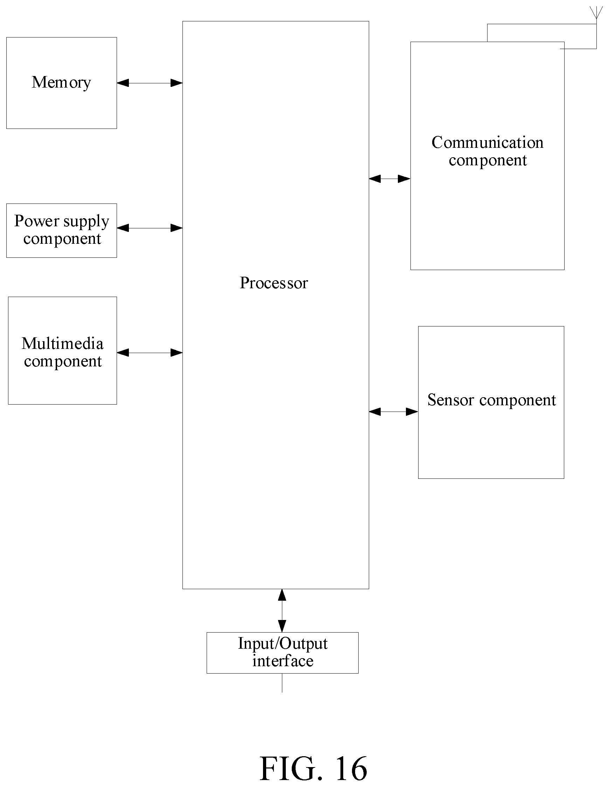

As shown in FIG. 16, the electronic device at least includes a processor, a memory, and a communication component, and may further include a sensor component, a power supply component, a multimedia component, and an input/output interface according to the actual need. The memory, the communication component, the sensor component, the power supply component, the multimedia component, and the input/output interface are connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, and the like. The processor may be a central processing unit (CPU), a graphic processing unit (GPU), a field programmable gate array (FPGA), an application specific integrated circuit (ASIC), a digital signal processing (DSP) chip, and the like. Other components, such as communication component, sensor component, power supply component and multimedia component may be implemented using universal components, which will not be specifically described here.

To sum up, according to the load modulation power amplifier provided in the present invention, by using the technical solution in which the driving-stage power amplifier is provided with the transconductance booster bias circuit, and the main circuit and the auxiliary circuit are provided with the harmonic impedance matching circuit, and the technical solution in which the main-circuit power amplifier is provided with the bias circuit with a phase adjustment circuit and the auxiliary-circuit power amplifier is provided with the bias circuit with a controllable enabling power point, and with reference to the output end provided with the load modulation power combiner that has less insertion loss, units collaboratively operate to realize linearization and high efficiency of the load modulation power amplifier, which can well meet the requirements of actual applications. Therefore, the load modulation power amplifier provided by the present invention has beneficial effects such as skillful and proper structural design, low design costs, high operating efficiency, and excellent circuit performance.

It should be noted that the foregoing embodiments are merely examples. The technical solutions of the embodiments may be combined with each other, all of which fall within the protection scope of the present invention.

It should be noted that the terms "first" and "second" are merely intended for a purpose of description, and shall not be understood as indicating or implying relative significance or implicitly indicating a quantity of indicated technical features. Therefore, a feature defined by "first" or "second" may explicitly or implicitly include one or more features. In the description of the present invention, unless otherwise explicitly specified, "a plurality of" means two or more than two; and

The load modulation power amplifier and the corresponding electronic device provided in the present invention are described in detail above. For those of ordinary skill in the art, any significant changes made to the present invention without deviating from its substantive content will constitute infringement of the patent rights of the present invention, and they will bear corresponding legal responsibilities.

**Claims**

1. A load modulation power amplifier, comprising a driving-stage power amplifier and a bias circuit thereof, an input power divider, a harmonic impedance controller, a main-circuit power amplifier and a bias circuit thereof, an auxiliary-circuit power amplifier and a bias circuit thereof, and a load modulation power combiner, wherein

   an input end of the driving-stage power amplifier and the bias circuit thereof is connected to a radio frequency signal input end, and is configured to drive and amplify an inputted radio frequency signal, and the amplified radio frequency signal is outputted to the input power divider;
   the input power divider is configured to divide one inputted radio frequency signal into two radio frequency signals with a phase difference of 90 degrees, wherein a radio frequency signal whose phase is +45 degrees passes through the harmonic impedance controller and then enters the main-circuit power amplifier; and a radio frequency signal whose phase is -45 degrees passes through the harmonic impedance controller and then enters the auxiliary-circuit power amplifier;
   the main-circuit power amplifier and the bias circuit thereof and the auxiliary-circuit power amplifier and the bias circuit thereof are both configured to amplify the inputted radio frequency signals, and the amplified radio frequency signals are separately outputted to the load modulation power combiner; and
   the load modulation power combiner is configured to perform power combination on the two inputted radio frequency signals to obtain one radio frequency signal, and has an output end connected to a radio frequency signal output end, wherein
   the driving-stage power amplifier is provided with a transconductance-enhanced bias circuit, the main-circuit power amplifier is provided with a phase-adjustable bias circuit, and the auxiliary-circuit power amplifier is provided with a bias circuit with a controllable enabling power point and the harmonic impedance controller.

2. The load modulation power amplifier according to claim 1, wherein
   an output end of the driving-stage power amplifier is connected to an input end of the input power divider, a first output end of the input power divider is connected to a first input end of the harmonic impedance controller, and a second output end of the input power divider is connected to a second input end of the harmonic impedance controller; a first output end of the harmonic impedance controller is connected to an input end of the main-circuit power amplifier and the bias circuit thereof, and a second output end of the harmonic impedance controller is connected to an input end of the auxiliary-circuit power amplifier and the bias circuit thereof; and an output end of the main-circuit power amplifier and the bias circuit thereof is connected to a first input end of the load modulation power combiner, and an output end of the auxiliary-circuit power amplifier and the bias circuit thereof is connected to a second input end of the load modulation power combiner.

3. The load modulation power amplifier according to claim 1, wherein

the driving-stage power amplifier and the bias circuit thereof comprise a driving and amplifying power tube, a first bias tube, a second bias tube, a first voltage stabilizing diode, a second voltage stabilizing diode, a third voltage stabilizing diode, a first filter capacitor, a second filter capacitor, a first feedback capacitor, a first bias resistor, a second bias resistor, and a first voltage stabilizing resistor, wherein
the driving and amplifying power tube has a base connected to the radio frequency signal input end, an emitter connected to a ground end, and a collector connected to an input end of the input power divider;
the first bias resistor, the first voltage stabilizing diode, the second voltage stabilizing diode, the first filter capacitor, and the first bias tube make up a main bias circuit, configured to provide a first bias current; and
the second bias resistor, the first voltage stabilizing resistor, the third voltage stabilizing diode, the second filter capacitor, the first feedback capacitor, and the second bias tube make up a transconductance-enhanced bias circuit, configured to provide a second bias current.

4. The load modulation power amplifier according to claim 3, wherein
in the main bias circuit, an emitter of the first bias tube is connected to the base of the driving and amplifying power tube, and a collector of the first bias tube and the first bias resistor are both connected to a first bias voltage terminal; and another end of the first bias resistor is connected to a base of the first bias tube, the first filter capacitor, and an anode of the first voltage stabilizing diode, a cathode of the first voltage stabilizing diode is connected to an anode of the second voltage stabilizing diode, and a cathode of the second voltage stabilizing diode and another end of the first filter capacitor are both connected to the ground end.

5. The load modulation power amplifier according to claim 3, wherein
in the transconductance-enhanced bias circuit, an emitter of the second bias tube is connected to the base of the driving and amplifying power tube and the first feedback capacitor, and another end of the first feedback capacitor is connected to the collector of the driving and amplifying power tube; a collector of the second bias tube and the second bias resistor are both connected to a first bias voltage terminal; and another end of the second bias resistor is connected to a base of the second bias tube, the first voltage stabilizing resistor, and the second filter capacitor, another end of the first voltage stabilizing resistor is connected to an anode of the third voltage stabilizing diode, and a cathode of the third voltage stabilizing diode and another end of the second filter capacitor are both connected to the ground end.

6. The load modulation power amplifier according to claim 3, wherein

when the driving-stage power amplifier outputs small power, the transconductance-enhanced bias circuit is in a disabled state, and does not provide the second bias current; and
when output power of the driving-stage power amplifier is increased and exceeds a set threshold, the transconductance-enhanced bias circuit is enabled, and provide the second bias current, to increase transconductance of the driving and amplifying power tube.

7. The load modulation power amplifier according to claim 1, wherein

the input power divider comprises a first inductor, a second inductor, a first capacitor, and a second capacitor, wherein an end of the first inductor, an end of the second inductor, an end of the first capacitor, and an end of the second capacitor are mutually connected and then connected, as an input end, to an output end of the driving-stage power amplifier and the bias circuit thereof;
the first inductor connected in parallel and the first capacitor connected in series make up a high-pass network, to cause a radio frequency signal phase of the high-pass network to lead by 45 degrees, and another end of the first capacitor is connected, as a first output end, to a first input end of the harmonic impedance controller; and
the second inductor connected in series and the second capacitor connected in parallel make up a low-pass network, to cause a radio frequency signal phase of the channel to lag by 45 degrees, and another end of the second inductor is used as a second output end and is connected to a second input end of the harmonic impedance controller.

8. The load modulation power amplifier according to claim 1, wherein

the harmonic impedance controller comprises a third inductor, a fourth inductor, a fifth inductor, a sixth inductor, a third capacitor, a fourth capacitor, a fifth capacitor, and a sixth capacitor, wherein

the third inductor, the fifth inductor, the third capacitor, and the fifth capacitor make up a harmonic impedance matching circuit of the main-circuit power amplifier;

the fourth inductor, the sixth inductor, the fourth capacitor, and the sixth capacitor make up a harmonic impedance matching circuit of the auxiliary-circuit power amplifier; and

the harmonic impedance matching circuit of the main-circuit power amplifier and the harmonic impedance matching circuit of the auxiliary-circuit power amplifier are completely structurally the same, and are both configured to perform matching between an optimal fundamental impedance point and an optimal harmonic impedance point.

9. The load modulation power amplifier according to claim 8, wherein in the harmonic impedance matching circuit of the main-circuit power amplifier, an end of the third inductor and an end of the third capacitor are mutually connected and then connected, as a first input end of the harmonic impedance controller, to a first output end of the input power divider; another end of the third inductor and another end of the third capacitor are mutually connected, and then are connected to the fifth capacitor in an aspect and connected, as a first output end of the harmonic impedance controller, to an input end of the main-circuit power amplifier and the bias circuit thereof in another aspect; and another end of the fifth capacitor is connected to the fifth inductor, and another end of the fifth inductor is connected to a ground end.

10. The load modulation power amplifier according to claim 1, wherein

the main-circuit power amplifier and the bias circuit thereof comprise a main-circuit amplifying power tube, a third bias tube, a first transistor, a second transistor, a fourth voltage stabilizing diode, a fifth voltage stabilizing diode, a third filter capacitor, a first coupling capacitor, a third bias resistor, and a fourth bias resistor, wherein all elements except the main-circuit amplifying power tube make up a bias circuit;

in the bias circuit, the third bias tube is an emitter follower, configured to provide a bias current for the main-circuit amplifying power tube, and the fourth bias resistor is configured to control magnitude of the bias current; and the third bias resistor, the first coupling capacitor, the first transistor, and the second transistor make up a phase adjustment circuit, configured to improve phase characteristics.

11. The load modulation power amplifier according to claim 10, wherein in the main-circuit power amplifier and the bias circuit thereof, a base of the main-circuit amplifying power tube is connected to an emitter of the third bias tube and then is connected to a first output end of the harmonic impedance controller; an emitter of the main-circuit amplifying power tube is connected to a ground end, and a collector of the main-circuit amplifying power tube is connected, as an output end, to a first input end of the load modulation power combiner; a collector of the third bias tube, the third bias resistor, and the fourth bias resistor are connected and then jointly connected to a second bias voltage end; another end of the third bias resistor is connected to a collector of the first transistor and a collector of the second transistor; a base of the first transistor is connected to the emitter of the third bias tube by using the third filter capacitor; a base and an emitter of the second transistor are connected in parallel and then connected to the ground end, and an emitter of the first transistor is connected to the ground end; a base of the third bias tube is connected to the third filter capacitor, an anode of the fourth voltage stabilizing diode, and another end of the fourth bias resistor; and another end of the third filter capacitor is connected to the ground end, a cathode of the fourth voltage stabilizing diode is connected to an anode of the fifth voltage stabilizing diode, and a cathode of the fifth voltage stabilizing diode is connected to the ground end.

12. The load modulation power amplifier according to claim 1, wherein

the auxiliary-circuit power amplifier and the bias circuit thereof comprise an auxiliary-circuit amplifying power tube, a fourth bias tube, a sixth voltage stabilizing diode, a fourth filter capacitor, a fifth bias resistor, and a second voltage stabilizing resistor, wherein all elements except the auxiliary-circuit amplifying power tube make up a bias circuit;

in the bias circuit, the fifth bias resistor is configured to control the enabling power point of the auxiliary-circuit power amplifier; and the fourth bias tube is an emitter follower, configured to provide a bias current for the auxiliary-circuit amplifying power tube; and

when the inputted radio frequency signal in a small signal state, the fourth bias tube is in a half cut-off state and provides no bias current; and when the inputted radio frequency signal is in a large signal state, the fourth bias tube begins to provide a bias current, to enable the auxiliary-circuit amplifying power tube, and realize a load modulation effect.

13. The load modulation power amplifier according to claim 12, wherein
in the auxiliary-circuit power amplifier and the bias circuit thereof, a base of the auxiliary-circuit amplifying power tube is connected to an emitter of the fourth bias tube and then is connected to a second output end of the harmonic impedance controller; an emitter of the auxiliary-circuit amplifying power tube is connected to a ground end, and a collector of the auxiliary-circuit amplifying power tube is connected, as an output end, to a second input end of the load modulation power combiner; a collector of the fourth bias tube and the fifth bias resistor are connected and then jointly connected to a third bias voltage end; and another end of the fifth bias resistor is connected to a base of the fourth bias tube, the second voltage stabilizing resistor, and the fourth filter capacitor, another end of the second voltage stabilizing resistor is connected to an anode of the sixth voltage stabilizing diode, and a cathode of the sixth voltage stabilizing diode and another end of the fourth filter capacitor are both connected to the ground end.

14. The load modulation power amplifier according to claim 1, wherein

the load modulation power combiner comprises a seventh inductor, an eighth inductor, a ninth inductor, a tenth inductor, an eleventh inductor, a seventh capacitor, an eighth capacitor, a ninth capacitor, a tenth capacitor, and an eleventh capacitor, wherein
the seventh inductor, the seventh capacitor, and the eighth capacitor make up a CLC-type main-circuit matching network;
the eighth inductor, the ninth inductor, the tenth inductor, the ninth capacitor, and the tenth capacitor make up a CL+CLL-type auxiliary-circuit matching network; and
the eleventh inductor and the eleventh capacitor make up an LC-type combinatorial matching network.

15. The load modulation power amplifier according to claim 14, wherein
in the load modulation power combiner, an end of the seventh capacitor is connected, as a first input end, to an output end of the main-circuit power amplifier and the bias circuit thereof, another end of the seventh capacitor is connected to the seventh inductor, another end of the seventh inductor is connected to the eighth capacitor and the eleventh inductor, and another end of the eighth capacitor is connected to a ground end; an end of the ninth capacitor and an end of the tenth capacitor are connected and then connected, as a second input end, to an output end of the auxiliary-circuit power amplifier and the bias circuit thereof, another end of the tenth capacitor is connected to the tenth inductor, and another end of the tenth inductor is connected to the ground end; another end of the ninth capacitor is connected to the eighth inductor and the ninth inductor, another end of the eighth inductor is connected to the ground end, and another end of the ninth inductor is connected to the eighth capacitor and the eleventh inductor; and another end of the eleventh inductor is connected to the eleventh capacitor and the radio frequency signal output end of the load modulation power amplifier, and another end of the eleventh capacitor is connected to the ground end.

16. An electronic device, comprising the load modulation power amplifier according to any one of claims 1 to 15.

Radio
frequency
signal input

AA

101

Main-circuit
power amplifier

104

T2

103

T1

102

Auxiliary-circuit
power amplifier

P

105

Output
matching
network

Radio
frequency
signal output

$R_L$

GND

FIG. 1

Radio frequency signal output

116 | Load modulation power combiner

114 | Main-circuit power amplifier and a bias circuit thereof

115 | Auxiliary-circuit power amplifier and a bias circuit thereof

113 | Harmonic impedance controller

112 | Input power divider

111 | Driving-stage power amplifier and a bias circuit thereof

Radio frequency signal input

FIG. 2

Radio frequency signal output end

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

## INTERNATIONAL SEARCH REPORT

| International application No. |
|---|
| **PCT/CN2024/110717** |

**A.    CLASSIFICATION OF SUBJECT MATTER**

H03F 1/32(2006.01)i

According to International Patent Classification (IPC) or to both national classification and IPC

**B.    FIELDS SEARCHED**

Minimum documentation searched (classification system followed by classification symbols)

IPC：H03F

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, IEEE, ISI, CNKI: 负载, 调制, 功率, 放大器, 偏置, 谐波, 阻抗, 主路, 辅路, 功合器, 合成, load, modulation, power, amplifier, bias, harmonic, impedance, main circuit, auxiliary circuit, combiner, synthesis

**C.    DOCUMENTS CONSIDERED TO BE RELEVANT**

| Category* | Citation of document, with indication, where appropriate, of the relevant passages | Relevant to claim No. |
|---|---|---|
| PX | CN 116979909 A (VANCHIP (TIANJIN) TECHNOLOGY CO., LTD.) 31 October 2023 (2023-10-31)<br>claims 1-16 | 1-16 |
| A | CN 116582093 A (VANCHIP (TIANJIN) TECHNOLOGY CO., LTD.) 11 August 2023 (2023-08-11)<br>description, paragraphs 4-30 | 1-16 |
| A | CN 114070210 A (VANCHIP (TIANJIN) TECHNOLOGY CO., LTD.) 18 February 2022 (2022-02-18)<br>entire document | 1-16 |
| A | CN 115037253 A (CHENGDU FLUXWORKS TECHNOLOGY CO., LTD.) 09 September 2022 (2022-09-09)<br>entire document | 1-16 |
| A | US 2011086600 A1 (TEXAS INSTRUMENTS, INC.) 14 April 2011 (2011-04-14)<br>entire document | 1-16 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **14 October 2024** | **23 October 2024** |

| Name and mailing address of the ISA/CN | Authorized officer |
|---|---|
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2024/110717**

| Patent document cited in search report | | | Publication date (day/month/year) | Patent family member(s) | | | Publication date (day/month/year) |
|---|---|---|---|---|---|---|---|
| CN | 116979909 | A | 31 October 2023 | None | | | |
| CN | 116582093 | A | 11 August 2023 | WO | 2024067226 | A1 | 04 April 2024 |
| CN | 114070210 | A | 18 February 2022 | WO | 2023138602 | A1 | 27 July 2023 |
| | | | | KR | 20240017068 | A | 06 February 2024 |
| | | | | US | 2024243710 | A1 | 18 July 2024 |
| CN | 115037253 | A | 09 September 2022 | None | | | |
| US | 2011086600 | A1 | 14 April 2011 | None | | | |

Form PCT/ISA/210 (patent family annex) (July 2022)